# EUROPÄISCHE PATENTANMELDUNG

(11) **EP 1 741 922 A1**
(43) Veröffentlichungstag der Anmeldung: **10.01.2007**
(21) Anmeldenummer: 06112992.0
(22) Anmeldetag: 24.04.2006
(51) Int. Cl.: F02M 51/06, F02M 61/08

(54) **Brennstoffeinspritzventil**

(30) Priorität: 28.06.2005 DE 102005029976
(71) Anmelder: ROBERT BOSCH GMBH, 70442 Stuttgart (DE)
(72) Erfinder: Mueller, Martin, 71696, Moeglingen (DE); Liskow, Uwe, 71679, Asperg (DE); Huebel, Michael, 70839, Gerlingen (DE); Bendel, Karl, 71701, Schwieberdingen (DE); Lang, Peter, 71287, Weissach (DE)

(57) **Zusammenfassung**

Bekannte Brennstoffeinspritzventile haben eine Rohrfeder, die einen Piezoaktor mit einer Vorspannung belastet. Nachteilig ist, dass die Rohrfeder durch die hochfrequente Hubbewegung des Piezoaktors zu Schwingungen angeregt wird, die als Körperschall auf angrenzende Bauteile übertragen werden und zu einer störenden Geräuschentwicklung führen.

Bei dem erfindungsgemäßen Brennstoffeinspritzventil werden die Schwingungen und die Geräuschentwicklung verringert.

Erfindungsgemäß ist zumindest ein Dämpfungselement (28) vorgesehen, das dämpfend auf die zumindest eine Rohrfeder (15) wirkt.

## Beschreibung

### Stand der Technik

Die Erfindung geht aus von einem Brennstoffeinspritzventil nach der Gattung des Hauptanspruchs.
Es ist schon ein Brennstoffeinspritzventil aus der DE 198 54 508 C1 bekannt mit einer Rohrfeder, die einen Piezoaktor mit einer Vorspannung belastet. Nachteilig ist, dass die Rohrfeder durch die hochfrequente Hubbewegung des Piezoaktors zu Schwingungen angeregt wird, die als Körperschall auf angrenzende Bauteile übertragen werden und zu einer störenden Geräuschentwicklung führen.

### Vorteile der Erfindung

Das erfindungsgemäße Brennstoffeinspritzventil mit den kennzeichnenden Merkmalen des Hauptanspruchs hat demgegenüber den Vorteil, daß auf einfache Art und Weise eine Verbesserung dahingehend erzielt wird, dass die Schwingungen der Rohrfeder verringert werden, indem zumindest ein Dämpfungselement vorgesehen ist, das dämpfend auf die zumindest eine Rohrfeder wirkt.

Durch die in den Unteransprüchen aufgeführten Maßnahmen sind vorteilhafte Weiterbildungen und Verbesserungen des im Hauptanspruch angegebenen Brennstoffeinspritzventils möglich.

Besonders vorteilhaft ist, wenn das zumindest eine Dämpfungselement eine an der Rohrfeder vorgesehene Ummantelung ist, da diese besonders einfach und kostengünstig herstellbar ist.

Weiterhin vorteilhaft ist, wenn das zumindest eine Dämpfungselement eine an der Rohrfeder anliegende weitere Rohrfeder ist, da dies eine sehr kompakte Bauweise ist, um eine gute Dämpfung der Rohrfeder zu erreichen.

Sehr vorteilhaft ist es, wenn das zumindest eine Dämpfungselement eine Gummifeder ist, die von der Rohrfeder ausgehend radial nach außen bis an eine Gehäusewandung eines Ventilgehäuses verläuft, da eine Gummifeder sehr wirkungsvoll Schwingungen dämpft.

Auch vorteilhaft ist, wenn das zumindest eine Dämpfungselement ein Reibelement ist, das reibend mit der Rohrfeder zusammenwirkt. Beispielsweise ist das Reibelement ein Vlies. Auch diese Ausführung lässt sich sehr Bauraum sparend realisieren.

Nach einer vorteilhaften Ausgestaltung ist vorgesehen, das zumindest eine Dämpfungselement aus einem Kunststoff, Elastomer oder Metall herzustellen.

Desweiteren vorteilhaft ist, wenn das zumindest eine Dämpfungselement an die zumindest eine Rohrfeder geklebt, vulkanisiert, geschweißt, gespritzt, gesteckt oder geclipst ist.

Darüber hinaus vorteilhaft ist, wenn die Rohrfeder rückstellend auf eine mit einem Ventilsitz zusammenwirkende Ventilnadel wirkt oder einen Aktor in axialer Richtung bezüglich einer Ventilachse vorspannt.

### Zeichnung

Ausführungsbeispiele der Erfindung sind in der Zeichnung vereinfacht dargestellt und in der nachfolgenden Beschreibung näher erläutert. Es zeigen Fig.1 im Schnitt eine Ansicht eines ersten Ausführungsbeispiels, Fig.2 ein erfindungsgemäßes Aktormodul nach einem zweiten Ausführungsbeispiel, Fig.3 eine Draufsicht des Aktormoduls gemäß einem dritten Ausführungsbeispiel, Fig.4 ein viertes Ausführungsbeispiel, Fig.5 ein fünftes Ausführungsbeispiel und Fig.6 ein sechstes Ausführungsbeispiel des erfmdungsgemäßen Brennstoffeinspritzventils.

### Beschreibung der Ausführungsbeispiele

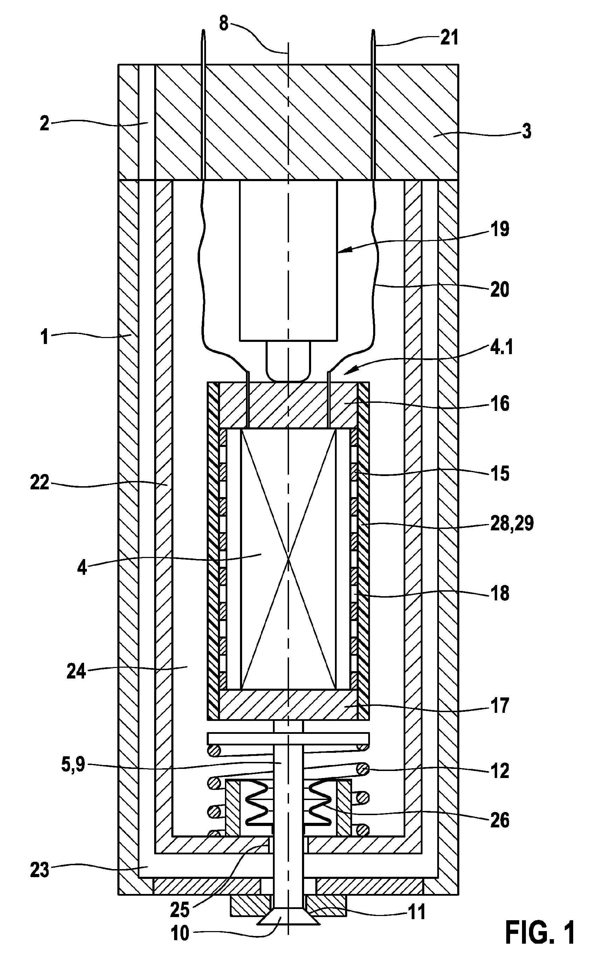

Fig.1 zeigt ein erstes Ausführungsbeispiel des erfindungsgemäßen Brennstoffeinspritzventils.

Das Brennstoffeinspritzventil wird beispielsweise bei der sogenannten Direkteinspritzung verwendet und dient dazu, Kraftstoff, beispielsweise Benzin oder Diesel, in einen Brennraum einer Brennkraftmaschine einzuspritzen.

Das Brennstoffeinspritzventil hat ein Ventilgehäuse 1 mit einem Eingangskanal 2 für den Kraftstoff. Das Ventilgehäuse 1 ist beispielsweise zylinderförmig ausgebildet mit einem stimseitig angeordneten Gehäusedeckel 3. In dem Ventilgehäuse 1 ist ein Aktor 4, beispielsweise ein piezoelektrischer oder magnetostriktiver Aktor, zur axialen Verstellung einer Ventilnadel 5 angeordnet. Die Ventilnadel 5 ist in dem Ventilgehäuse 1 axial beweglich bezüglich einer Ventilachse 8 vorgesehen und weist beispielsweise einen dem Aktor 4 zugewandten Nadelschaft 9 und einen dem Aktor 4 abgewandten Ventilschließkörper 10 auf. Der Ventilschließkörper 10 wirkt mit einem am Ventilgehäuse 1 ausgebildeten Ventilsitz 11 zusammen.

Der piezoelektrische Aktor 4 besteht aus einer Vielzahl von piezokeramischen Schichten, die durch Anlegen einer elektrischen Spannung eine Dehnung in axialer Richtung bezüglich der Ventilachse 8 ausführen. Dabei wird der sogenannte inverse piezoelektrische Effekt ausgenutzt, bei dem elektrische Energie in mechanische Energie umgewandelt wird.

Der durch das Anlegen der elektrischen Spannung erzeugte Hub des piezoelektrischen Aktors 4 wird auf die Ventilnadel 5 übertragen, die beispielsweise einen Hub von 40 bis 50 Mikrometer ausführt und das Brennstoffeinspritzventil auf diese Weise öffnet. Durch Abschalten der elektrischen Spannung verkürzt sich der Aktor 4 und die Ventilnadel 5 wird mittels einer Rückstellfeder 12 wieder in Richtung des Ventilsitzes 11 zurückbewegt und schließt das Brennstoffeinspritzventil. Die Rückstellfeder 12 ist beispielsweise als Schraubenfeder ausgebildet, kann aber auch eine sogenannte Rohrfeder sein.

Der piezoelektrische Aktor 4 ist zum Schutz vor Zug- und Biegespannungen beispielsweise in einer Aktorhülse 15 zwischen einem Aktorkopf 16 und einem Aktorfuß 17 angeordnet und in axialer Richtung bezüglich der Ventilachse 8 auf Druck vorgespannt. Der Aktor 4, die Aktorhülse 15, der Aktorkopf 16 und der Aktorfuß 17 bilden ein sogenanntes Aktormodul. Die Aktorhülse 15 ist beispielsweise als sogenannte Rohrfeder ausgeführt, die zur Erhöhung der Elastizität beispielsweise Ausnehmungen 18 aufweist. Die Ausnehmungen 18 sind beispielsweise knochenförmig ausgeführt. Die Aktorhülse 15 ist aus Metall, beispielsweise Stahl, hergestellt. Der Aktorkopf 16 ist an einem stimseitigen, der Ventilnadel 4 abgewandten Ende der Aktorhülse 15 angeordnet und mit der Aktorhülse 15 stoffschlüssig und/oder kraftschlüssig verbunden, beispielsweise mittels Schweißen. Der Aktorfuß 17 ist an einem stimseitigen, der Ventilnadel 4 zugewandten Ende der Aktorhülse 15 angeordnet und ebenfalls stoffschlüssig und/oder kraftschlüssig mit der Aktorhülse 15 verbunden, beispielsweise mittels Schweißen.

Der Aktor 4 weist zumindest zwei Aktoranschlüsse 4.1 auf, die über elektrische Zuleitungen 20, beispielsweise elektrische Kabel, mit am Ventilgehäuse 1 vorgesehenen Steckeranschlüssen 21 elektrisch verbunden sind. Der Aktor 4 wird über diese Steckeranschlüsse 21 an eine externe Spannungsquelle angeschlossen. Die Steckeranschlüsse 21 sind beispielsweise an dem Gehäusedeckel 3 angeordnet.

Da sich der Aktor 4 und die übrigen Komponenten des Brennstoffeinspritzventils, beispielsweise das Ventilgehäuse 1, wegen unterschiedlicher thermischer Ausdehnungskoeffizienten bei Temperaturänderung unterschiedlich stark ausdehnen, ist ein hydraulischer Koppler 19 vorgesehen, der die Differenzen in der unterschiedlichen Längenausdehnung ausgleicht. Der hydraulische Koppler 19 stellt somit sicher, daß das Brennstoffeinspritzventil mit der Ventilnadel 5 unabhängig von der jeweiligen Temperatur des Brennstoffeinspritzventils jeweils den gleichen Hub ausführt. Es dürfen keine Hubverluste auftreten, bei denen der Hub des Aktors 4 nicht vollständig auf die Ventilnadel 5 übertragen wird und somit der Hub der Ventilnadel 5 kleiner ist als der Hub des Aktors 4. Der hydraulische Koppler 19 ist beispielsweise zwischen dem Gehäusedeckel 3 und dem Aktorkopf 16 der Aktorhülse 15 angeordnet und beispielsweise zylinderförmig ausgeführt. Bei zeitlich schnellen auf den hydraulischen Koppler 19 wirkenden Bewegungsvorgängen, wie beispielsweise der Ausdehung des Aktors 4 bei Beschalten mit einer elektrischen Spannung, verhält sich der hydraulische Koppler 19 als extrem steifes Bauteil. Bei zeitlich langsamen Bewegungsvorgängen, wie beispielsweise der Dehnung aufgrund von Temperaturänderungen, verändert er seine axiale Länge bezüglich der Ventilachse 8 und gleicht auf diese Weise Dehnungsdifferenzen aus.

Der hydraulische Koppler 19, der Aktor 4 mit der Aktorhülse 15 und die Ventilnadel 5 sind beispielsweise konzentrisch bezüglich der Ventilachse 8 angeordnet.

Um den Aktor 4 und den hydraulischen Koppler 19 gegenüber dem Kraftstoff zu kapseln, ist im Ventilgehäuse 1 beispielsweise ein Aktorgehäuse 22 vorgesehen, das den Aktor 4 und den hydraulischen Koppler 19 hermetisch umschließt und gegenüber dem Kraftstoff abdichtet. Das Aktorgehäuse 22 ist beispielsweise zylinderförmig ausgeführt und teilt den Innenraum des Ventilgehäuses 1 in einen mit Kraftstoff beladenen und mit dem Eingangskanal 2 strömungsverbundenen Druckraum 23 und einen den Aktor 4 und den hydraulischen Koppler 19 aufweisenden Aktorraum 24. Der Nadelschaft 9 der Ventilnadel 5 verläuft im Aktorraum 24 vom Aktorfuß 17 ausgehend in vom Aktor 4 abgewandter Richtung und durchragt das Aktorgehäuse 22 durch eine Öffnung 25 bis in den Druckraum 23. Die Öffnung 25 ist mittels einer elastischen Dichtung 26 abgedichtet, so daß kein Kraftstoff aus dem Druckraum 23 in den Aktorraum 24 gelangt.

Durch eine hochfrequente Hubbewegung des Aktors 4 wird die Aktorhülse 15 zu Schwingungen angeregt, deren Frequenzen im akustisch hörbaren Bereich liegen. Die Schwingungen der Aktorhülse 15 werden beim Stand der Technik auf angrenzende Bauteile der Brennkraftmaschine übertragen, dabei u.U. verstärkt und sind als Geräusch in ungewünschter Weise wahrnehmbar.

Um die Schwingungen der Aktorhülse 15 und die dadurch verursachte Geräuschentwicklung zu verringern, ist erfindungsgemäß zumindest ein Dämpfungselement 28 vorgesehen, das schwingungsdämpfend auf die zumindest eine Aktorhülse 15 wirkt. Durch das Dämpfungselement 28 wird die Amplitude der Schwingungen verringert, so dass die Aktorhülse 15 mechanisch weniger stark beansprucht ist und dadurch eine höhere Lebensdauer aufweist.

Das zumindest eine Dämpfungselement 28 ist an der Aktorhülse 15 angeordnet und liegt an dieser beispielsweise flächig an. Beispielsweise ist das zumindest eine Dämpfungselement 28 an einem Innenumfang und/oder an einem Außenumfang der Aktorhülse 15 angeordnet. Das Dämpfungselement 28 und der Aktor 4 sind beispielsweise konzentrisch bezüglich der Ventilachse 8 angeordnet.

Die Dämpfungswirkung des Dämpfungselementes 28 beruht auf innerer Reibung innerhalb des Werkstoffes des Dämpfungselementes 28 und/oder auf äußerer Reibung beispielsweise mit dem Ventilgehäuse 1 oder mit der Aktorhülse 15. Durch die Reibung wird ein Teil der durch die Hubbewegung des Aktors 4 eingeleiteten Energie dissipiert.

Gemäß einem ersten Ausführungsbeispiel ist das Dämpfungselement 28 als elastische Ummantelung 29 ausgebildet, die vorwiegend durch innere Reibung dämpfend wirkt. Die Ummantelung 29 der Aktorhülse 15 besteht beispielsweise aus einem Kunststoff oder Elastomer. Sie wird beispielsweise durch Spritzgießen, Aufkleben oder Vulkanisieren mit der Aktorhülse 15 fest verbunden. Beispielsweise ist die Ummantelung ein elastischer Schlauch, der elastisch vorgespannt auf der Aktorhülse 15 sitzt, indem der Innendurchmesser des Schlauches geringfügig kleiner ausgeführt ist als der Durchmesser der Aktorhülse 15.

Auch die auf die Ventilnadel 5 wirkende Rückstellfeder 12 kann erfindungsgemäß schwingungsgedämpft sein.

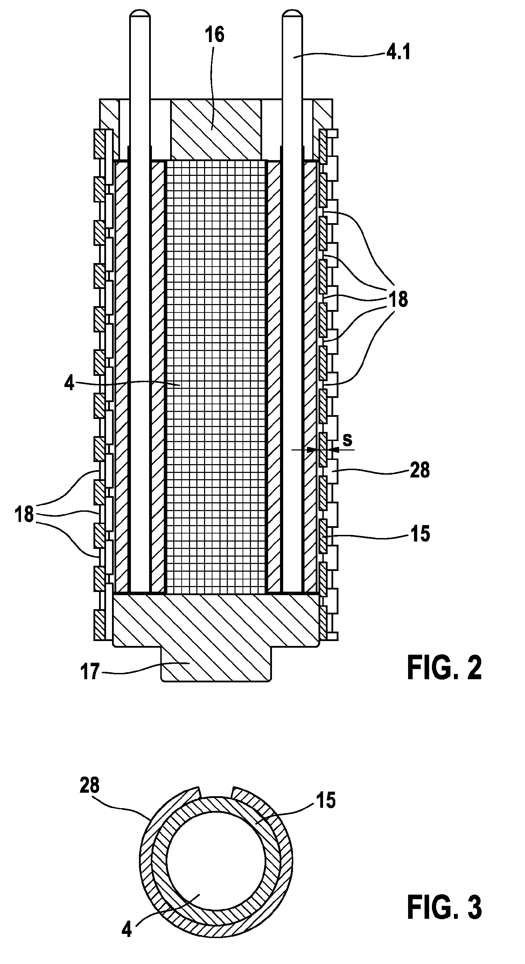

Fig.2 zeigt ein erfindungsgemäßes Aktormodul nach einem zweiten Ausführungsbeispiel.

Bei dem Brennstoffeinspritzventil nach Fig.2 sind die gegenüber dem Brennstoffeinspritzventil nach Fig.1 gleichbleibenden oder gleichwirkenden Teile durch die gleichen Bezugszeichen gekennzeichnet.

Das Brennstoffeinspritzventil nach Fig.2 unterscheidet sich von dem Brennstoffeinspritzventil nach Fig.1 darin, dass als Dämpfungselement 28 eine weitere Rohrfeder dient. Die weitere Rohrfeder 28 liegt an dem Außenumfang der Rohrfeder 15 flächig an. Die weitere Rohrfeder 28 ist beispielsweise aus Stahl hergestellt. Sie ist wie die Aktorhülse 15 mit dem Aktorkopf 16 und dem Aktorfuß 17 verschweißt oder direkt an der Aktorhülse 15 befestigt. Die weitere Rohrfeder 28 weist eine zu der Rohrfeder 15 unterschiedliche Federsteifigkeit auf, so dass die beiden Rohrfedern 15,28 unterschiedliche Eigenfrequenzen haben und sich gegenseitig dämpfen. Die Rohrfeder 15 und die weitere Rohrfeder 28 bilden auf diese Weise ein Federpaket mit parallel geschalteten Federn. Die Rohrfeder 15 und die weitere Rohrfeder 28 haben gemeinsam etwa die gleiche Wandstärke s wie die Ausführung mit nur einer einzigen Rohrfeder in Fig.1.

Des weiteren ist möglich, anstatt einer weiteren Rohrfeder 28 nur eine einzige Rohrfeder 15 zu verwenden, deren Mantel spiralförmig über mehr als 360 Grad derart aufgewickelt ist, dass die einzelnen Wicklungen eng aneinander liegen und sich durch Reibung gegenseitig dämpfen.

Fig.3 zeigt eine Ansicht des Aktormoduls in Richtung der Ventilachse gemäß einem dritten Ausführungsbeispiel.

Bei dem Brennstoffeinspritzventil nach Fig.3 sind die gegenüber dem Brennstoffeinspritzventil nach Fig. 1 und Fig.2 gleichbleibenden oder gleichwirkenden Teile durch die gleichen Bezugszeichen gekennzeichnet.

Anstatt der weiteren Rohrfeder kann als Dämpfungselement 28 auch eine geschlitzte Blechhülse verwendet werden, die auf die Aktorhülse 15 aufgeclipst oder eng anliegend um die Aktorhülse 15 herum gewickelt wird, so dass sie die Aktorhülse 15 zumindest teilweise umgibt. Bei dieser Ausführung beruht die Dämpfungswirkung vorwiegend auf einer äußeren Reibung aufgrund einer Relativbewegung zwischen der Aktorhülse 15 und dem Dämpfungselement 28.

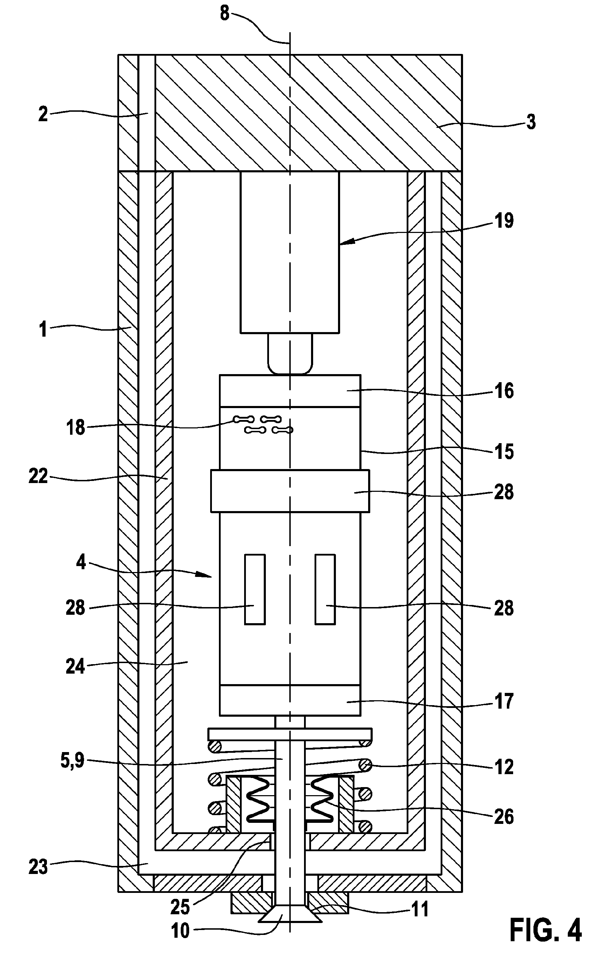

Fig.4 zeigt ein viertes Ausführungsbeispiel des erfmdungsgemäßen Brennstoffeinspritzventils.

Bei dem Brennstoffeinspritzventil nach Fig.4 sind die gegenüber dem Brennstoffeinspritzventil nach Fig.1 bis Fig.3 gleichbleibenden oder gleichwirkenden Teile durch die gleichen Bezugszeichen gekennzeichnet.

Das Brennstoffeinspritzventil nach Fig.4 unterscheidet sich von dem Brennstoffeinspritzventil nach Fig.2 und Fig.3 darin, dass das Dämpfungselement 28 die Aktorhülse 15 nicht vollständig umgibt, sondern hülsenförmig nur über einen Teil der axialen Erstreckung der Aktorhülse 15 verläuft oder streifenförmig nur an einem Teil des Umfangs der Aktorhülse 15 vorgesehen ist.

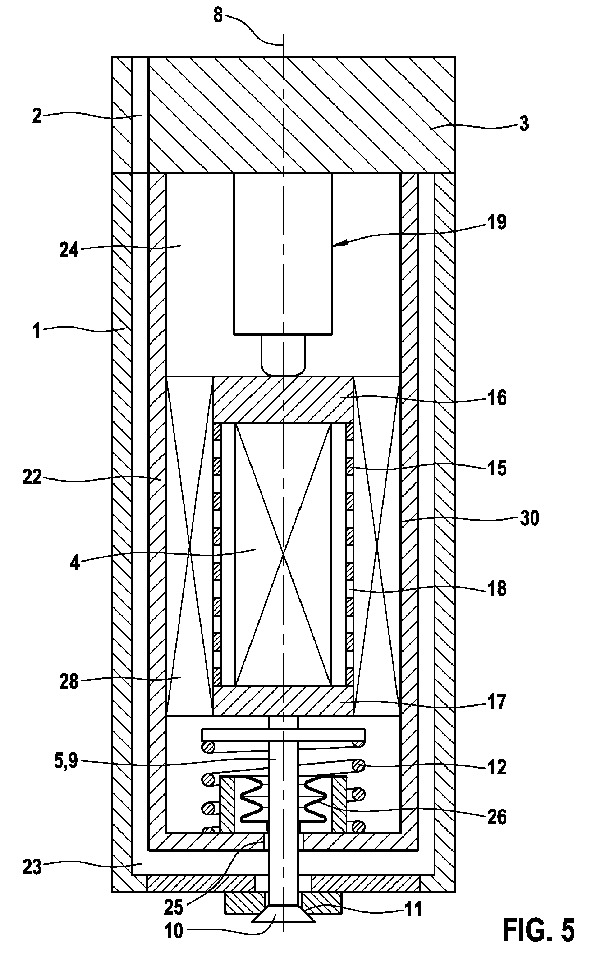

Fig.5 zeigt ein fünftes Ausführungsbeispiel des erfmdungsgemäßen Brennstoffeinspritzventils.

Bei dem Brennstoffeinspritzventil nach Fig.5 sind die gegenüber dem Brennstoffeinspritzventil nach Fig.1 bis Fig.4 gleichbleibenden oder gleichwirkenden Teile durch die gleichen Bezugszeichen gekennzeichnet.

Das Brennstoffeinspritzventil nach Fig.5 unterscheidet sich von dem Brennstoffeinspritzventil nach Fig.2 bis Fig.4 darin, dass das Dämpfungselement 28 nicht als Rohrfeder, sondern als Gummifeder ausgebildet ist, die von der Aktorhülse 15 ausgehend radial nach außen bis an eine Gehäusewandung 30 des Ventilgehäuses 1, beispielsweise des Aktorgehäuses 22, verläuft. Die Gummifeder ist sowohl mit der Aktorhülse 15 als auch mit der Gehäusewandung 30 fest verbunden, beispielsweise mittels Kleben oder Vulkanisieren.

Alternativ kann das Dämpfungselement 28 auch ein reibend mit der Aktorhülse 15 zusammenwirkendes Reibelement sein, das beispielsweise ein aus einer Vielzahl von Fasern bestehendes Vlies ist, das zwischen der Aktorhülse 15 und der Gehäusewandung 30 des Ventilgehäuses 1 eingepresst ist. Das Reibelement kann auch ein wellig gewickeltes Blech sein, das entweder an der Aktorhülse 15 oder an der Gehäusewandung 30 befestigt ist, so dass durch Relativbewegung zwischen der Aktorhülse 15 und der Gehäusewandung 30 eine äußere Reibung auf die Aktorhülse 15 wirkt. Durch die äußere Reibung zwischen der Aktorhülse 15 und dem Vlies wird eine gute Dämpfung der Schwingungen erreicht.

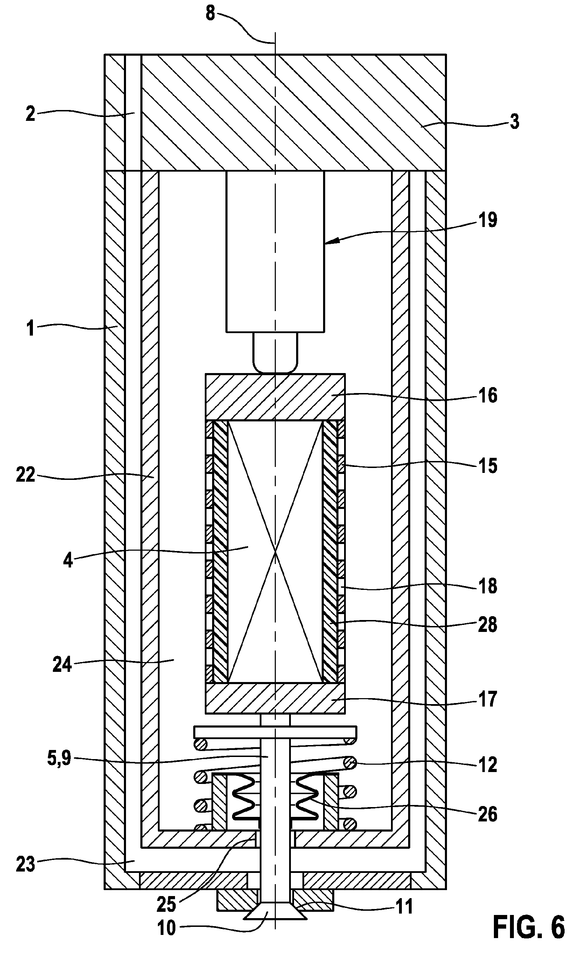

Fig.6 zeigt ein sechstes Ausführungsbeispiel des erfindungsgemäßen Brennstoffeinspritzventils.

Bei dem Brennstoffeinspritzventil nach Fig.6 sind die gegenüber dem Brennstoffeinspritzventil nach Fig.1 bis Fig.5 gleichbleibenden oder gleichwirkenden Teile durch die gleichen Bezugszeichen gekennzeichnet.

Das Brennstoffeinspritzventil nach Fig.6 unterscheidet sich von dem Brennstoffeinspritzventil nach Fig.1 bis Fig.5 darin, dass das Dämpfungselement 28 an dem Innenumfang der Aktorhülse 15 angeordnet ist.

## Patentansprüche

1. Brennstoffeinspritzventil mit zumindest einer Rohrfeder (15), **dadurch gekennzeichnet, dass** zumindest ein Dämpfungselement (28) vorgesehen ist, das dämpfend auf die zumindest eine Rohrfeder (15) wirkt.

2. Brennstoffeinspritzventil nach Anspruch 1, **dadurch gekennzeichnet, dass** das zumindest eine Dämpfungselement (28) eine an der Rohrfeder (15) vorgesehene Ummantelung ist.

3. Brennstoffeinspritzventil nach Anspruch 1, **dadurch gekennzeichnet, dass** das zumindest eine Dämpfungselement (28) eine an der Rohrfeder (15) anliegende weitere Rohrfeder ist.

4. Brennstoffeinspritzventil nach Anspruch 1, **dadurch gekennzeichnet, dass** das zumindest eine Dämpfungselement (28) eine Gummifeder ist, die von der Rohrfeder (15) ausgehend radial nach außen bis an eine Gehäusewandung (30) eines Ventilgehäuses (1) verläuft.

5. Brennstoffeinspritzventil nach Anspruch 1, **dadurch gekennzeichnet, dass** das zumindest eine Dämpfungselement (28) ein Reibelement ist, das reibend mit der Rohrfeder (15) zusammenwirkt.

6. Brennstoffeinspritzventil nach Anspruch 5, **dadurch gekennzeichnet, dass** das Reibelement ein Vlies oder ein Blech ist.

7. Brennstoffeinspritzventil nach Anspruch 1, **dadurch gekennzeichnet, dass** das zumindest eine Dämpfungselement (28) aus einem Kunststoff, Elastomer oder Metall besteht.

8. Brennstoffeinspritzventil nach Anspruch 1, **dadurch gekennzeichnet, dass** das zumindest eine Dämpfungselement (28) an die zumindest eine Rohrfeder (15) geklebt, vulkanisiert, geschweißt, gespritzt, gesteckt oder geclipst ist.

9. Brennstoffeinspritzventil nach Anspruch 1, **dadurch gekennzeichnet, dass** die Rohrfeder (15) rückstellend auf eine mit einem Ventilsitz (11) zusammenwirkende Ventilnadel (5) wirkt oder einen Aktor (4) in axialer Richtung bezüglich einer Ventilachse (8) vorspannt.
